# EUROPEAN PATENT SPECIFICATION

(11) **EP 1 879 036 B1**
(45) Date of publication and mention of the grant of the patent: **13.05.2009**
(21) Application number: 07013777.3
(22) Date of filing: 13.07.2007
(51) Int. Cl.: G01R 15/18, G01R 15/20

(54) **Device and method for measuring a current flowing in an electrical conductor**
Vorrichtung und Verfahren zur Messung eines Stromflusses in einem elektrischen Leiter
Dispositif et procédé pour la mesure du courant circulant dans un conducteur électrique

(30) Priority: 14.07.2006 DE 102006032763
(43) Date of publication of application: 16.01.2008
(73) Proprietor: Lisa Dräxlmaier GmbH, 84137 Vilsbiburg (DE); EPCOS AG, 81669 München (DE)
(72) Inventor: Hausperger, Christian, 84155 Bonbruck (DE); Kindler, Edgar, 84036 Landshut (DE); Röllgen, Bernhard, 81673 München (DE)
(74) Representative: HOFFMANN EITLE

(56) References cited:
- EP-A- 1 067 391
- EP-A- 1 450 176
- GB-A- 1 071 848
- US-A- 5 180 970

## Description

### Field of the Invention

The present invention relates to a device for measuring a current flowing in an electrical conductor according to the preamble of claim 1 and a method for measuring a current flowing in an electrical conductor according to the preamble of claim 13.

In the field of automotive engineering, the rising number of electrical consumer loads in motor vehicles is leading to an ever-increasing demand for power in the on-board electrical system. As a result of this, the load on the on-board battery in particular, which serves as a backup during operation of the vehicle engine and maintains the vehicle's voltage supply in the engine's switched off condition, is becoming ever greater. This may lead to the battery failing to be completely charged during operation of the engine particularly where the vehicle is subject to increased use for short-run operations. The result of this may be that the vehicle breaks down with a flat battery or cannot be started due to the battery's voltage being too low.

Energy management systems are increasingly being used in vehicles to prevent this from happening. Such an energy management system is intended to ensure that the charging condition of the battery does not reach a critical state and is intended to ensure that the battery's charging balance is positive. Analysis of the battery's condition, which results from the measured variables for battery current, battery voltage and battery temperature, forms the basis of such a system. In this case it is primarily the detection of the charging or discharging current which is most significant for keeping the battery at a non-critical charging level and for ensuring the vehicle's ability to start.

The challenge in detecting the charging or discharging current lies in the fact that the currents to be measured extend over a very wide range, for example from -200 A to 1500 A. In addition, relatively low currents within the range of a few amperes or even milliamperes must also be measurable which occur, for example, as residual charge currents in an almost completely charged battery. Correspondingly, a suitable sensor for energy management in vehicles must cover this wide range and thus have a high dynamic response.

### Technological Background

Relevant background information can be found in US 5180970, EP 1067391, GB 1071848 and in EP 1450176.

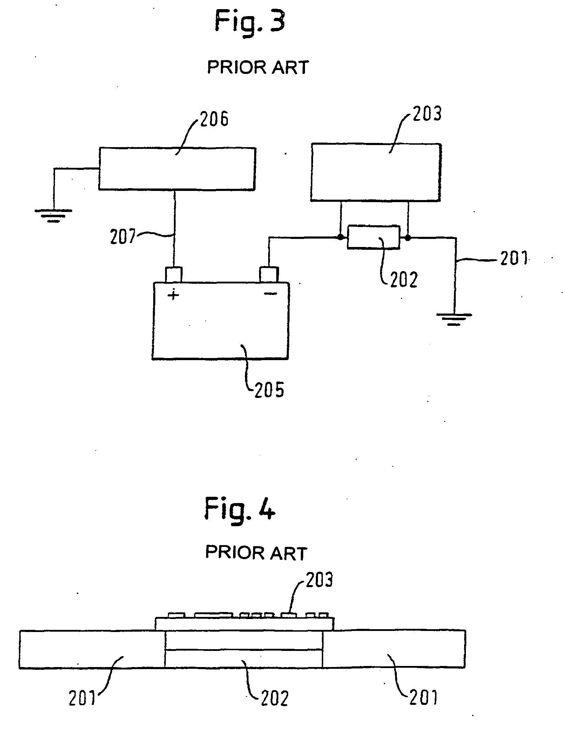

The sensor shown in Figures 3 and 4 is known from the prior art for use in a motor vehicle for monitoring flowing currents. A measuring shunt 202 is inserted in earth conductor 201 to detect the battery current. An appropriate analyzing unit 203 directly measures the voltage drop at the measuring shunt and from this calculates the current flowing. In this case the measuring shunt may be made, for example, of Manganin.

Figure 3 shows the measuring set-up to be realized with this sensor. A car battery 205 is connected to the vehicle earth by way of an earth conductor 201. The sensor, comprising measuring shunt 202 and analyzing unit 203, is integrated into earth conductor 201. Electrical consumer loads 206 of the motor vehicle are connected to the positive terminal of battery 205 by way of a conductor 207.

The disadvantage of this solution known from the prior art is that the measuring shunt has to be integrated into the conductor carrying the current, which causes additional design expenditure since it is necessary to ensure that shear and tensile forces are kept away from the measuring shunt. A deformation of the measuring shunt may influence the measured result and in the extreme case leads to a fault in the sensor. A further disadvantage is that there is necessarily a heat loss via the measuring shunt. Even when using low resistances, such as, e.g., a 100 mW measuring shunt, heat is still lost and has to be dissipated.

### Object of the invention

Based on this prior art, it is an object of the present invention to provide a device and a method for measuring a current flowing in an electrical conductor which decrease the drawbacks of the prior art and enable reliable measurement of a current in an electrical conductor over a broad measuring range.

### Description of the invention

This object is achieved by a device for measuring a current flowing in an electrical conductor according to claim 1 and by a method for measuring a current flowing in an electrical conductor according to claim 13.

The device has a magnetic circuit for coupling to the electrical conductor and provided with an air gap, and a magnetic field sensitive component is disposed in the magnetic circuit's air gap for measuring the magnetic field generated by the electrical conductor. According to the invention, at least one control core is disposed in the air gap of the magnetic circuit to control the air gap whereby the control core has a control winding for magnetic saturation of the respective control core in order to control the effective length of the air gap, and the magnetic field sensitive component is disposed in the air gap.

Since the current sensor is based on the principle of measuring the magnetic field of a conductor through which a current is flowing, an external magnetic field may influence the measured result. Such magnetic fields which influence the measured result may be generated, for example, by loud-speaker systems operated in a motor vehicle or by current-carrying lines, in particular lines in which high currents are flowing. In addition, the terrestrial magnetic field may also have an influence on the measurement.

According to the invention, the magnetic circuit, the magnetic field sensitive component and/or the at least one control core are accordingly enclosed, at least in part, by a magnetic shield.

It is possible by means of this magnetic shield to provide a shield, at least in part, against magnetic fields that would normally act upon the magnetic circuit, the magnetic field sensitive component and/or the control cores.

The term magnetic shield is understood here to mean that an (external) magnetic field is weakened by the magnetic shield. In particular, a magnetic field acting upon a component is weakened by the magnetic shield such that a component situated behind or within the magnetic shield is exposed to a weaker magnetic field than a component situated outside the magnetic field. In other words, the magnetic field is stronger outside the magnetic shield than within the magnetic shield. Thus, provision of a shield is not understood to mean that the magnetic field completely disappears within or behind the shield, although this may, of course, also be the case. It is only important for the magnetic shield to weaken the external magnetic field acting upon the components.

Furthermore, the air gap length effective for the magnetic field sensitive component is variable due to the disposition of the magnetic field sensitive component in the air gap together with the at least one control core. If the control core is unsaturated, the effective air gap length substantially corresponds to the extension of the magnetic field sensitive component. If, on the other hand, the control core is saturated by applying a current to the control winding, the control core becomes ineffective for the magnetic circuit. The magnetic field sensitive component is then located in an overall air gap thus generated, which is enlarged by the length of the now saturated and thus ineffective control core.

Due to its special construction, the device thus assembled has a measuring range switching that is realized by passing a current through the control winding of the control core. By passing a current through the control winding of the control core, and due to the magnetic saturation of the control core associated with this, the control core becomes ineffective for the magnetic circuit. As a result, the effective air gap of the magnetic circuit is enlarged and the field bound in the magnetic circuit is weakened. In this way it is possible, using the magnetic field sensitive element, to measure large currents which induce large magnetic fields in the magnetic circuit, as the field bound in the magnetic circuit is weakened by the enlarged air gap at high currents.

On the other hand, to measure smaller currents, the control winding of the control core is switched off so that the control core fills a larger area of the air gap with magnetizable material. Thus with the control winding switched off, the effective air gap consists only of the magnetic field sensitive component.
As a result, the dynamic response of the magnetic field sensitive component is utilized particularly well. It is possible in particular to prevent the magnetic field to be measured from exceeding the existing dynamic response of the magnetic field sensitive component and thus to prevent erroneous measurements from occurring. Therefore, the device makes it possible to ensure an effective measuring range switching due to adaptation of the magnetic field to be measured by changing the air gap's effective length.

In a preferred example embodiment of the present invention, the magnetic shield is designed in the form of a container enclosing the magnetic circuit, the magnetic field sensitive component and/or the control core. This container can in particular also be a box in which essentially all of the components of the remaining device that are influenceable by a magnetic field are received. As a result, it is possible to achieve a particularly reliable shielding of the magnetic field since all of the parts sensitive to an external magnetic field can be disposed inside the container.

The container can be open on at least one side so as to facilitate access to the individual components of the device.

Furthermore, the container and/or the magnetic shield may, however, also be substantially closed except for through-holes for electrical and magnetic conductors. The electrical conductors may be, for example, feed lines to the control windings or feed and output lines of the magnetic field sensitive component, particularly of a Hall probe. Furthermore, the electrical conductor, the current of which is to be measured, must, of course, also arrive inside the container through a through-hole. Magnetic conductors may, for example, also be parts of the magnetic circuit that are disposed outside the container, or other magnetic conductors of the device.
In a preferred example embodiment, the magnetic shield represents the outermost spatial boundary of the device. Thus, in particular all of the parts of the device that might be influenced by an outer or external magnetic field are disposed inside the magnetic shield. However, it goes without saying that supply lines to the windings or the magnetic field sensitive component may be disposed outside the magnetic shield. Furthermore, analyzing and control devices may likewise be situated outside the magnetic shield. These may, however, also be included inside the magnetic shield so as to form a closed system.

In one embodiment in particular the magnetic shield is designed so as to enclose all measurement, control and analyzing components. In other words, only supply lines for electrical power for driving the individual components, and output lines through which the measured current is signaled are needed. In addition, the electrical conductor to be measured must, of course, also be supplied.

Preferably, the magnetic shield includes a magnetically conductive material, in particular a metallic material such as, for example, a Mu metal, in order to achieve as effective a shielding of the components reacting to the magnetic field as possible.

In this case, the magnetic shield is preferably disposed so as to provide a substantial shield against an external magnetic field. This is particularly advantageous if the components that are influenced by the external magnetic field are not completely enclosed by the magnetic shield. This is the case, for example, if the components are received in a container open on one side. It is preferred in this case for the magnetic shield to be disposed so as to shield the components that may be influenced by the magnetic field as well as possible against the external magnetic field. For example, the closed sides of the shield may then be facing towards an interfering, current-carrying conductor or towards an interfering loud-speaker magnet. In this context, it is clear that the magnetic shield may also be an individual shielding sheet or another flat shielding element that is arranged in a corresponding position.

Such a suitable magnetic shield may be achieved especially by the selection and geometric design of the magnetic shield. In particular the parameters of the material of the actual shield, the material thickness, the geometric configuration of the shield and the distance between the shield and the sensor, have an influence in this regard. Furthermore, the field direction and the field strength of the interfering external magnetic field also play a part and must be taken into consideration when it comes to the geometric design and the orientation of the shield.

The magnetic shield preferably comprises at least one through-hole for passing through electrical and/or magnetic conductors, as already described further above.

In an advantageous embodiment of the invention, two separate control cores are disposed in the air gap and the magnetic field sensitive component is disposed between the control cores. Due to the construction with two separate control cores and disposition of the magnetic field sensitive component between them, the magnetic field sensitive component, e.g. a Hall sensor, is disposed in the central area of the air gap. If these two cores are specifically saturated by passing a current through the control winding, then the Hall sensor is located in the centre of the effective air gap thus arising. The bound magnetic field is lowest at this point as a result of which the highest possible currents can be measured.

Furthermore, by the provision of two separate control cores it is possible to realize a three-stage switching, that is to say a switching between a state in which no single control core is saturated, a state in which a single control core is saturated and a state in which both control cores are saturated.

If the sensor is operated with high sensitivity, that is the control windings are switched off, the magnetic field sensitive component measures the magnetic field carried in the overall magnetic circuit. The overall magnetic circuit then consists of the magnetic circuit plus the control cores. With the control windings switched on, the magnetic field sensitive component is located in exactly the position in the now effective air gap at which the magnetic field is weakest, that is in the centre of the air gap. As a result the maximum achievable measuring range switching is attained. The measuring range is maximized accordingly.

Preferably, the device is disposed in the vicinity of an earth conductor or a positive conductor of a vehicle battery, especially a motor vehicle battery. The device is advantageously disposed in the vicinity of an electrical load or a group of electrical loads of a vehicle, especially of a motor vehicle. On the one hand this makes it possible to easily realize a leak current monitor and a charging or discharging current monitor, on the other it is possible to monitor the current consumption of individual loads or individual load groups in a vehicle. Due to the magnetic shield, the device can also be used in magnetically difficult environments, in particular also in the engine compartment of a motor vehicle or in the vicinity of large electrical consumer loads.

The method for measuring a current flowing in an electrical conductor may be carried out by means of the device described above. According to the invention, in order to measure the current, at least one measurement of the magnetic field is carried out in the magnetic circuit without excitation of the control core and a further measurement of the magnetic field is carried out in the magnetic circuit with saturated control core.

If two control cores are provided, a further measurement can only be carried out in a single saturated control core. In a further embodiment of the method, a measurement may initially be performed with saturation of a first control core and then with saturation of the second control core, by means of which a double or triple measuring range switching becomes possible with the result that currents can be measured reliably in a broad range.

The invention also relates to a use of the device in a motor vehicle for monitoring of currents in the vehicle's on-board electrical system and furthermore to a use of the method described in the motor vehicle for monitoring of currents in the on-board electrical system of a motor vehicle. The device described or the method described may, however, also be used as a current sensor in other areas of applications.

### Brief Description of the Drawings

In the following, the invention is described exemplarily by means of preferred embodiments. At the same time, the same reference numbers are used for the same components.

The drawings show:
- Figure 1: a schematic diagram of the device in a first embodiment having a first magnetic shield;
- Figure 2: a schematic view of the device in a second embodiment having a second magnetic shield;
- Figure 3: a schematic diagram of a sensor for measuring battery current according to the prior art; and
- Figure 4: a sectional diagram of the measuring shunt and the analyzing unit from Figure 3 according to the prior art.

### Detailed Description of the Drawings

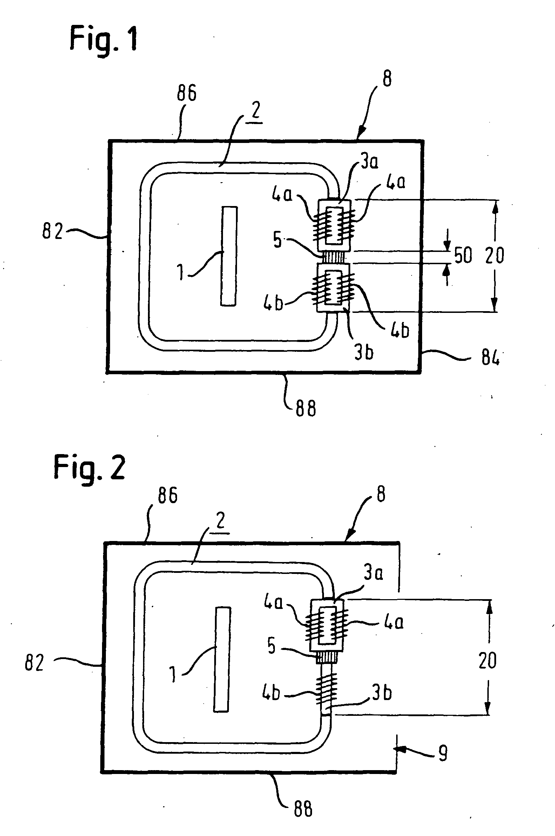

Figure 1 shows a schematic diagram of a first embodiment of a device for measuring a current flowing in an electrical conductor.

The device serves to measure a current flowing through an electrical conductor 1. The device comprises a magnetic circuit 2, which has an air gap 20. In the air gap 20 two control cores 3a and 3b are disposed. It is also possible according to an embodiment not shown for only a single control core to be provided.

The control cores 3a and 3b connect directly on their respective sides, facing towards magnetic circuit 2, to magnetic circuit 2. In the embodiment shown, control cores 3a, 3b are designed as ferrite cores forming a substantially rectangular frame. On the two long sides of the substantially rectangular ferrite core frame 3a, 3b control windings 4a and 4b are attached respectively.

Between the two control cores 3a, 3b a gap 50 is formed, in which a magnetic field sensitive component 5 is disposed. In the example embodiment shown, magnetic field sensitive component 5 is a Hall sensor. The two control cores 3a, 3b and magnetic field sensitive component 5 completely fill air gap 20 of magnetic circuit 2. In an example embodiment which is not shown, air gap 20 of magnetic circuit 2 is not, however, completely filled but rather an air gap is provided, for example, between the control cores and the magnetic field sensitive component.

To measure the magnetic field surrounding electrical conductor 1, and thus to measure the current flowing through the electrical conductor, the magnetic field coupled into magnetic circuit 2 is measured in magnetic field sensitive component 5.

Furthermore, a magnetic shield 8 is shown which in the example embodiment shown is illustrated in a sectional diagram. It can be clearly recognized that the shield 8 is substantially similar to a container or box having walls 82, 84, 86, 88. The two walls lying in the plane of Figure 1 are not shown, but are present. The magnetic shield 8 consists of metallic material such that the components lying within the magnetic shield 8, in particular magnetic circuit 2, control cores 3a, 3b, as well as magnetic field sensitive component 5, are shielded against an externally acting magnetic field. As a result, the magnetic field acting upon the components is weaker inside the container than it would be without the shield.

It is clear that through-holes must be provided, for example, for conductor 1 as well as for supply lines to control windings 4a, 4b and to magnetic field sensitive component 5. These through-holes are not shown in the Figures and are advantageously designed so as to ensure the greatest possible magnetic shielding. In particular, the through-holes in magnetic shield 8 are selected so as to tightly enclose the respective conductor in order to prevent the penetration of magnetic field lines.

If the currents flowing through electrical conductor 1 are small, no current at all is applied to control windings 4a, 4b in order to set the device's sensitivity to high. The air gap of the effective magnetic circuit is then only in the order of magnitude of the air gap between the two control cores 3a, 3b, which corresponds to the width of component 5.

The magnetic field bound in magnetic circuit 2 is thus carried to the magnetic field sensitive component.

However, if large currents are to be measured, a control current is applied to control windings 4a, 4b so that control cores 3a, 3b are saturated. The air gap of magnetic circuit 2 thus effectively corresponds to air gap 20, as the saturated control cores do not contribute any more to the magnetic circuit. Magnetic field sensitive component 5 is then situated in the present example embodiment in the centre of air gap 20 of magnetic circuit 2. At this location the magnetic field of magnetic circuit 2 is at its weakest. Thus it is possible in this arrangement to measure an especially large current through electrical conductor 1 without exceeding the magnetic field sensitive component's dynamic response.

Figure 2 shows a second possible embodiment. The embodiment of Figure 2 differs from that shown in Figure 1, on the one hand, by the arrangement of the second control core 3b in respect of the first control core 3a. The plane lying within the frame of control core 3b is turned in this case by 90 degrees vis-à-vis the plane lying within control core 3a. As a result it is possible to minimize the area of the air gap and thus further improve the device's sensitivity for low currents. In this case the area of the air gap corresponds to a square area with a side length corresponding to the width of ferrite core frame 3a and 3b respectively. By this means it is possible to achieve a further increase in the device's sensitivity at low currents.

On the other hand, Figure 2 likewise shows a magnetic shield 8 which also has walls 82, 86, 88. As can be clearly seen from Figure 2, the wall 84 that is shown in Figure 1 does not exist, but rather the magnetic shield 8 is open towards the side 9. On the one hand, this enables simple assembly and, on the other hand, the individual components are easily accessible within the magnetic shield 8. Furthermore, the material costs for the non-existing wall can be saved and the magnetic shield 8 can be implemented as a whole with a lower weight. In addition, ventilation and/or cooling of the components received in the magnetic shield 8 is improved since the magnetic shield 8 is open.

In the case of Figure 2, the opening 9 is advantageously oriented so as to face away from a possibly interfering external magnetic field. The wall 82 of magnetic shield 8 is thus disposed in particular towards the external magnetic interference field.

In a preferred manner of operation, magnetic field sensitive component 5 is connected to an analyzing device (not shown) which has control means (not shown) for separate excitation of control windings 4a, 4b. By separate excitation of control windings 4a, 4b it is possible to achieve a measuring process for measuring the currents in which, in a first measuring range, no excitation at all is applied to control windings 4a, 4b, in a second measuring range, one of control windings 4a or 4b is charged with an excitation current with the result that respective control core 3a, 3b is saturated, and then to set a third measuring range for measuring high currents, both control cores 3a, 3b are saturated by applying corresponding control currents to control windings 4a, 4b. Magnetic field sensitive component 5 is then situated in the centre of the virtual air gap arising as a result.

In an embodiment that is not shown, it is furthermore conceivable that more than only two control cores are disposed in the air gap and that, by combining the respective saturation currents or by combining the respective saturations of the control cores, different air gap lengths can be generated in respect of magnetic field sensitive component 5. As a result of this it may be possible to realize a further adaptation of the measuring range switching to the measuring ranges required in each case.

The device thus constructed is especially suitable for monitoring currents in motor vehicles due to the large measuring range switching.

## Claims

1. A device for measuring a current flowing in an electrical conductor (1), said device comprising a magnetic circuit (2) for coupling to the electrical conductor and having an air gap (20), wherein a magnetic field sensitive component (5) for measuring the magnetic field generated by the electrical conductor is disposed in the air gap of the magnetic circuit, **characterized in that** at least one control core (3a, 3b) having a control winding (4a, 4b) for magnetic saturation of the control core to control the effective length of the air gap is disposed in the air gap of the magnetic circuit, wherein the magnetic circuit, the magnetic field sensitive component and/or the control core are enclosed, at least in part, by a magnetic shield (8, 82, 84, 86, 88).

2. A device according to claim 1, wherein the magnetic shield is designed in the form of a container, in particular a box, which encloses the magnetic circuit, the magnetic field sensitive component and/or the control core.

3. A device according to claim 2, wherein the container is open on at least a side (9).

4. A device according to claim 2, wherein the container is substantially closed except for through-holes for electrical and/or magnetic conductors.

5. A device according to one of the preceding claims, wherein the magnetic shield represents the outermost spatial boundary of the device.

6. A device according to one of the preceding claims, wherein the magnetic shield includes a metallic material, in particular a Mu metal.

7. A device according to one of the preceding claims, wherein the magnetic shield is disposed so as to provide a substantial shield against an external magnetic field.

8. A device according to one of the preceding claims, wherein the magnetic shield has at least one through-hole for passing through electrical and/or magnetic conductors.

9. A device according to one of the preceding claims, wherein the two control cores are disposed in the air gap.

10. A device according to claim 9, wherein the magnetic field sensitive component is disposed between the control cores.

11. A device according to one of the preceding claims, wherein the device is disposed in the vicinity of a ground conductor or a positive conductor of a vehicle battery, in particular a motor vehicle battery.

12. A device according to one of the preceding claims, wherein the device is disposed in the vicinity of an electrical consumer load or a group of electrical consumer loads of a vehicle, in particular a motor vehicle.

13. A method for measuring a current flowing in an electrical conductor by means of a device according to one of the preceding claims, **characterized in that** at least one measurement of the magnetic field is carried out in the magnetic circuit without excitation of the control core and one measurement of the magnetic field is carried out in the magnetic circuit with saturated control core.

14. A method according to claim 13, wherein two control cores are provided and at least one further measurement is carried out with a single saturated control core.

15. Use of a device according to one of claims 1 to 12 in a motor vehicle to monitor currents in the on-board electrical system of the motor vehicle.

16. Use of a method according to one of claims 13 or 14 in a motor vehicle to monitor currents in the on-board electrical system of the motor vehicle.

## Patentansprüche

1. Vorrichtung zur Messung eines in einem elektrischen Leiter (1) fließenden Stroms, mit einem einen Luftspalt (20) aufweisenden Magnetkreis (2) zur Kopplung mit dem elektrischen Leiter, wobei in dem Luftspalt des Magnetkreises ein magnetfeldsensitives Bauteil (5) zur Messung des vom elektrischen Leiter erzeugten Magnetfelds angeordnet ist, **dadurch gekennzeichnet, dass** in dem Luftspalt des Magnetkreises mindestens ein Steuerkern (3a, 3b) angeordnet ist, der eine Steuerwicklung (4a, 4b) zur magnetischen Sättigung des Steuerkerns zur Steuerung der effektiven Länge des Luftspalts aufweist, wobei der Magnetkreis, das magnetfeldsensitive Bauteil und/oder der Steuerkern zumindest teilweise von einer magnetischen Abschirmung (8, 82, 84, 86, 88) umgeben sind.

2. Vorrichtung gemäß Anspruch 1, wobei die magnetische Abschirmung in der Form eines den Magnetkreis, das magnetfeldsensitive Bauteil und/oder den Steuerkern umgebenden Behältnisses, insbesondere eines Kastens, ausgebildet ist.

3. Vorrichtung gemäß Anspruch 2, wobei das Behältnis an mindestens einer Seite (9) geöffnet ist.

4. Vorrichtung gemäß Anspruch 2, wobei das Behältnis bis auf Durchtrittsöffnungen für elektrische und/oder magnetische Leiter im Wesentlichen geschlossen ist.

5. Vorrichtung gemäß einem der vorstehenden Ansprüche, wobei die magnetische Abschirmung die äußerste räumliche Begrenzung der Vorrichtung darstellt.

6. Vorrichtung gemäß einem der vorstehenden Ansprüche, wobei die magnetische Abschirmung ein metallisches Material, insbesondere ein Mu-Metall, umfasst.

7. Vorrichtung gemäß einem der vorstehenden Ansprüche, wobei die magnetische Abschirmung so angeordnet ist, dass ein externes Magnetfeld im Wesentlichen abgeschirmt wird.

8. Vorrichtung gemäß einem der vorstehenden Ansprüche, wobei die magnetische Abschirmung mindestens eine Durchtrittsöffnung zum Durchtritt elektrischer und/oder magnetischer Leiter aufweist.

9. Vorrichtung gemäß einem der vorstehenden Ansprüche, wobei zwei Steuerkerne in dem Luftspalt angeordnet sind.

10. Vorrichtung gemäß Anspruch 9, wobei das magnetfeldsensitive Bauteil zwischen den Steuerkernen angeordnet ist.

11. Vorrichtung nach einem der vorstehenden Ansprüche, wobei die Vorrichtung im Bereich eines Masseleiters oder eines Plusleiters einer Fahrzeugbatterie, insbesondere einer Kraftfahrzeugbatterie, angeordnet ist.

12. Vorrichtung nach einem der vorstehenden Ansprüche, wobei die Vorrichtung im Bereich eines elektrischen Verbrauchers oder einer Gruppe elektrischer Verbraucher eines Fahrzeugs, insbesondere eines Kraftfahrzeugs, angeordnet ist.

13. Verfahren zum Messen eines in einem elektrischen Leiter fließenden Stroms mittels einer Vorrichtung gemäß einem der vorstehenden Ansprüche, **dadurch gekennzeichnet, dass** mindestens eine Messung des Magnetfeldes in dem Magnetkreis ohne Anregung des Steuerkerns, und eine Messung des Magnetfeldes in dem Magnetkreis bei gesättigtem Steuerkern durchgeführt wird.

14. Verfahren gemäß Anspruch 13, wobei zwei Steuerkerne vorgesehen sind und mindestens eine weitere Messung bei einem einzigen gesättigten Steuerkern durchgeführt wird.

15. Verwendung einer Vorrichtung gemäß einem der Ansprüche 1 bis 12 in einem Kraftfahrzeug zur Überwachung von Strömen im Bordnetz des Kraftfahrzeugs.

16. Verwendung eines Verfahrens gemäß einem der Ansprüche 13 oder 14 in einem Kraftfahrzeug zur Überwachung von Strömen im Bordnetz des Kraftfahrzeugs.

## Revendications

1. Dispositif pour mesurer un courant circulant dans un conducteur électrique (1), ledit dispositif comprenant un circuit magnétique (2) pour couplage au conducteur électrique et ayant un entrefer (20), dans lequel un composant sensible au champ magnétique (5) pour mesurer le champ magnétique généré par le conducteur électrique est disposé dans l'entrefer du circuit magnétique, **caractérisé en ce qu'**au moins un noyau de commande (3a, 3b) ayant un enroulement de commande (4a, 4b) pour une saturation magnétique du noyau de commande pour commander la longueur utile de l'entrefer est disposé dans l'entrefer du circuit magnétique, dans lequel le circuit magnétique, le composant sensible au champ magnétique et/ou le noyau de commande sont enfermés, au moins en partie, par un blindage magnétique (8, 82, 84, 86, 88).

2. Dispositif selon la revendication 1, dans lequel le blindage magnétique est conçu sous la forme d'un récipient, en particulier un boîtier, qui enferme le circuit magnétique, le composant sensible au champ magnétique et/ou le noyau de commande.

3. Dispositif selon la revendication 2, dans lequel le récipient est ouvert sur au moins un côté (9).

4. Dispositif selon la revendication 2, dans lequel le récipient est substantiellement fermé à l'exception de trous traversants pour des conducteurs électriques et/ou magnétiques.

5. Dispositif selon l'une des revendications précédentes, dans lequel le blindage magnétique représente la limite spatiale la plus extérieure du dispositif.

6. Dispositif selon l'une des revendications précédentes, dans lequel le blindage magnétique inclut un matériau métallique, en particulier un métal Mu.

7. Dispositif selon l'une des revendications précédentes, dans lequel le blindage magnétique est disposé de manière à fournir un blindage substantiel contre un champ magnétique externe.

8. Dispositif selon l'une des revendications précédentes, dans lequel le blindage magnétique a au moins un trou traversant pour faire passer des conducteurs électriques et/ou magnétiques.

9. Dispositif selon l'une des revendications précédentes, dans lequel les deux noyaux de commande sont disposés dans l'entrefer.

10. Dispositif selon la revendication 9, dans lequel le composant sensible au champ magnétique est disposé entre les noyaux de commande.

11. Dispositif selon l'une des revendications précédentes, dans lequel le dispositif est disposé à proximité d'un conducteur de terre ou d'un conducteur positif d'une batterie de véhicule, en particulier d'une batterie de véhicule à moteur.

12. Dispositif selon l'une des revendications précédentes, dans lequel le dispositif est disposé à proximité d'une charge consommatrice électrique ou d'un groupe de charges consommatrices électriques d'un véhicule, en particulier d'un véhicule à moteur.

13. Procédé pour mesurer un courant circulant dans un conducteur électrique au moyen d'un dispositif selon l'une des revendications précédentes, **caractérisé en ce qu'**au moins une mesure du champ magnétique est effectuée dans le circuit magnétique sans excitation du noyau de commande et une mesure du champ magnétique est effectuée dans le circuit magnétique avec un noyau de commande saturé.

14. Procédé selon la revendication 13, dans lequel deux noyaux de commande sont prévus et au moins une autre mesure est effectuée avec un noyau de commande unique saturé.

15. Utilisation d'un dispositif selon l'une des revendications 1 à 12 dans un véhicule à moteur pour surveiller des courants dans le système électrique embarqué du véhicule à moteur.

16. Utilisation d'un procédé selon l'une des revendications 13 ou 14 dans un véhicule à moteur pour surveiller des courants dans le système électrique embarqué du véhicule à moteur.
